# EUROPÄISCHE PATENTSCHRIFT

(11) **EP 3 734 668 B1**
(45) Veröffentlichungstag und Bekanntmachung des Hinweises auf die Patenterteilung: **27.08.2025**
(21) Anmeldenummer: 20000162.6
(22) Anmeldetag: 20.04.2020
(51) Int. Cl.: H10D 8/00, H10D 62/824, H10D 62/40, H10D 62/852

(54) **STAPELFÖRMIGE HOCHSPERRENDE INGAAS-HALBLEITERLEISTUNGSDIODE**
STACKED HIGH BARRIER INGAAS SEMICONDUCTOR POWER DIODE
DIODE EMPILÉE DE PUISSANCE À SEMI-CONDUCTEUR EN INGAAS À BLOCAGE HAUT

(30) Priorität: 30.04.2019 DE 102019003068
(43) Veröffentlichungstag der Anmeldung: 04.11.2020
(73) Patentinhaber: AZUR SPACE Solar Power GmbH, 74072 Heilbronn (DE); 3-5 Power Electronics GmbH, 01217 Dresden (DE)
(72) Erfinder: Fuhrmann, Daniel, 74081 Heilbronn (DE); Keller, Gregor, 74080 Heilbronn (DE); Wächter, Clemens, 74348 Lauffen am Neckar (DE); Dudek, Volker, 76275 Ettlingen (DE)
(74) Vertreter: Koch Müller Patentanwaltsgesellschaft mbH

(56) Entgegenhaltungen:
- US-A- 4 471 367
- WINDHORN T H ET AL: "The Electron Velocity-Field Characteristic for n-In0.53 Ga0.47 As at 300K", IEEE ELECTRON DEVICE LETTERS,, vol. EDL-3, no. 1, 1 January 1982 (1982-01-01), pages 18 - 20, XP001281070, ISSN: 0193-8576
- LIAN JI ET AL: "Compositionally undulating step-graded InAsyP1-y buffer layer growth by metal-organic chemical vapor deposition", JOURNAL OF CRYSTAL GROWTH, vol. 363, 1 January 2013 (2013-01-01), pages 44 - 48, XP055116886, ISSN: 0022-0248, DOI: 10.1016/j.jcrysgro.2012.09.035
- JUNG DAEHWAN ET AL: "Design and growth of multi-functional InAsP metamorphic buffers for mid-infrared quantum well lasers on InP", JOURNAL OF APPLIED PHYSICS, AMERICAN INSTITUTE OF PHYSICS, US, vol. 125, no. 8, 25 January 2019 (2019-01-25), XP012234994, ISSN: 0021-8979, [retrieved on 20190125], DOI: 10.1063/1.5054574

## Beschreibung

Die Erfindung betrifft eine stapelförmige hochsperrende InGaAs-Leistungshalbleiterdiode.

Aus "GaAs Power Devices" von German Ashkinazi, ISBN 965-7094-19-4, Seite 8 und 9 ist eine hochspannungsfeste PIN-Halbleiterdiode aus GaAs bekannt.

Stapelförmige hochsperrende InGaAs-Halbleiterleistungsdioden und entsprechende Herstellungsverfahren sind aus den Druckschriften DE 10 2016 013 540 A1, DE 10 2016 013 541 A1, DE 10 2016 015 056 A1, DE 10 2017 002 935 A1 und DE 10 2017 002 936 A1 bekannt.

Aus T. H. Windhorn et al.: "The Electron Velocity-Field Charactteristic for n-In0.54Ga0.47As at 300k", IEEE Electron Device Letters, Bd. EDL-3, Nr. 1, 01.01.1982, Seiten 18-20, XP001281070, ISSN: 0193 - 8576 ist eine InGaAs-Diodenstruktur auf einem InP-Substrat und mit einem InGaAs-Driftgebiet bekannt.

Aus der US 4 471 367 A ist eine Schottky-Diode mit InGaAs-Halbleiterschichten auf einer InP-Substratschicht bekannt.

Verschiedene metamorphe Pufferschichtfolgen auf einem InP-Substrat sind aus Lian Ji et al.: "Compositionally undulating step-graded InAsyP1-y buffer layer growth by metal-organic chemical vapor deposition", Journal of Crystal Growth, Bd. 363, 01.01.2013, Seiten 44-48, XP055116886, ISSN: 0022-0248, DOI: 10.1016/j.jcrysgro.2012.09.035 oder aus D. Jung et al.: " Design and growth of multi-functional InAsP metamorphic buffers for mid-infrared quantum well lasers on InP", Journal of Applied Physics, American Institute of Physics, Bd. 125, Nr. 8, 25.01.2019, XP012234994, ISSN: 0021-8979, DOI: 10.1063/1,5054574 bekannt.

Gattungsgemäße Dioden weisen Durchbruchspannungen oberhalb von 200V auf und sollten neben einer niedrigen Vorwärtsspannung einen geringen Serienwiderstand aufweisen, um die Verlustleistung zu reduzieren. Des Weiteren sollten die Dioden in Sperrrichtung möglichst geringe Leckströme von unterhalb 1 µA aufweisen.

Vor diesem Hintergrund besteht die Aufgabe der Erfindung darin, eine Vorrichtung anzugeben, die den Stand der Technik weiterbildet.

Die Aufgabe wird durch eine stapelförmige hochsperrende InGaAs-Halbleiterleistungsdiode mit den Merkmalen des Patentanspruchs 1 oder des Patentanspruchs 2 gelöst. Vorteilhafte Ausgestaltungen der Erfindung sind jeweils Gegenstand von Unteransprüchen.

Gemäß dem ersten Gegenstand der Erfindung wird eine stapelförmige hochsperrende InGaAs-Halbleiterleistungsdiode bereitgestellt, aufweisend eine zumindest gebietsweise ausgebildete erste metallische Anschlusskontaktschicht und einen hochdotierten Halbleiterkontaktbereich eines ersten Leitfähigkeitstyps mit einer-Dotierstoffkonzentration größer als 1•10¹⁸ N/cm³ und mit einer ersten Gitterkonstante.

Des Weiteren ist eine Driftschicht eines zweiten Leitfähigkeitstyps mit der ersten Gitterkonstante und mit einer Schichtdicke größer als 10 µm vorgesehen.

Eine Halbleiterkontaktschicht des zweiten Leitfähigkeitstyps mit einer Oberseite und einer Unterseite und mit einer Dotierstoffkonzentration größer als 5•10¹⁷ N/cm³ und einer Schichtdicke oberhalb 0,5 µm und kleiner als 850 µm ist oberhalb einer zweiten metallischen Anschlusskontaktschicht angeordnet.

Die vorgenannten Bereiche und Schichten sind in der genannten Reihenfolge angeordnet.

Die zweite metallische Anschlusskontaktschicht ist stoffschlüssig mit der Unterseite der Halbleiterkontaktschicht verbunden, wobei die Halbleiterkontaktschicht zumindest an der Unterseite eine zweite Gitterkonstante aufweist und die zweite Gitterkonstante die Gitterkonstante von InP ist.

Die Driftschicht und der hochdotierte Halbleiterkontaktbereich umfassen jeweils eine InGaAs Verbindung oder bestehen aus InGaAs.

Die erste Gitterkonstante liegt oberhalb der Gitterkonstanten von GaAs.

Gemäß dem zweiten Gegenstand der Erfindung wird eine stapelförmige hochsperrende III-V-Halbleiterleistungsdiode bereitgestellt, aufweisend eine zumindest gebietsweise ausgebildete erste metallische Anschlusskontaktschicht und einen hochdotierten Halbleiterkontaktbereich eines zweiten Leitfähigkeitstyps mit einer Dotierstoffkonzentration größer als 1•10¹⁸ N/cm³ und mit einer ersten Gitterkonstante.

Des Weiteren ist eine Driftschicht eines zweiten Leitfähigkeitstyps mit der ersten Gitterkonstante und mit einer Schichtdicke größer als 10 µm vorgesehen.

Eine Halbleiterkontaktschicht des ersten Leitfähigkeitstyps mit einer Oberseite und einer Unterseite und mit einer Dotierstoffkonzentration größer als 5•10¹⁷ N/cm³ und einer Schichtdicke oberhalb 0,5 µm und kleiner als 150 µm oder kleiner als 450 µm oder kleiner als 650 µm oder kleiner als 850 µm ist oberhalb einer zweiten metallischen Anschlusskontaktschicht angeordnet.

Die vorgenannten Bereiche und Schichten sind in der genannten Reihenfolge angeordnet.

Die zweite metallische Anschlusskontaktschicht ist stoffschlüssig mit der Unterseite der Halbleiterkontaktschicht verbunden, wobei die Halbleiterkontaktschicht zumindest an der Unterseite eine zweite Gitterkonstante aufweist und die zweite Gitterkonstante die Gitterkonstante von InP ist.

Die Driftschicht und der hochdotierte Halbleiterkontaktbereich umfassen jeweils eine InGaAs Verbindung oder bestehen aus InGaAs.

Die erste Gitterkonstante liegt oberhalb der Gitterkonstanten von GaAs.

Es sei angemerkt, dass mit dem Ausdruck "besteht aus III-V Elementen" genannte Stoffe ohne weitere III-V Elemente verstanden werden, jedoch Dotierstoffen wie beispielsweise Zink oder Silizium oder Zinn oder Kohlenstoff umfasst sind. Folglich bedeutet beispielsweise "besteht aus InGaAs", dass als III-V Elemente ausschließlich Indium und Galium und Arsen jedoch nicht Al oder P usw. eingebaut sind.

Mit dem Ausdruck "eine Verbindung umfassend" bedeutet entsprechend für InGaAs, dass neben Indium und Galium und Arsen weitere III-V Elemente wie beispielsweise Phosphor oder Aluminium enthalten sein können, zusätzlich zu eventuellen Dotierstoffen.

Vorzugsweise sind die III-V Halbleiterschichten, d.h. die InGaAs- und die InP-Halbleiterschichten jeweils zueinander zumindest teilweise planar oder teilweise wannenförmig ausgebildet, wobei die laterale Ausbildung der jeweiligen III-V Halbleiterschichten für die planare Anordnung vorzugsweise gleich groß ist.

Auch sei angemerkt, dass der Ausdruck "Halbleiterschicht" mit dem Ausdruck "Halbleiterbereich" vorzugsweise synonym verwendet wird. Jedoch wird mit dem Ausdruck "Halbleiterbereich" eine im Allgemeinen wannenförmige Ausbildung des Halbleiterbereichs und mit dem Ausdruck "Halbleiterschicht" im Allgemeinen eine Schicht zumindest mit einer planen Unterseite und / oder mit einer planen Oberseite bezeichnet.

Auch sei angemerkt, dass die metallischen Anschlusskontaktschichten jeweils elektrisch sehr gut leitfähig sind und umfassen oder bestehen vorzugsweise aus einer oder mehreren Metallschichten, wobei die Metallschichten bevorzugt auch Verbindungen wie beispielsweise Ge und / oder Au und / oder Pd umfassen.

Es versteht sich, dass die jeweiligen Halbleiterkontaktschichten an einer Oberseite oder an einer Unterseite der InGaAs Halbleiterleistungsdioden unmittelbar angrenzend zu den metallischen Anschlusskontaktschichten ausgebildet sind.

Es versteht sich des Weiteren, dass trotz der Bezeichnung als InGaAs-Halbleiterleistungsdioden LHD an der Unterseite in Ausführungsformen ein InP Substrat ausgebildet ist.

Des Weiteren versteht es sich, dass die Anschlusskontaktschichten vorzugsweise mittels Bonddrähten mit Kontaktfingern, den sogenannten Pins, verschaltet sind, indem die Halbleiterleistungsdioden auf einem Träger beispielsweise in Form eines Leadframes angeordnet sind.

Auch sei angemerkt, dass die Durchbruchsspannung der hochsperrenden InGaAs Halbleiterleistungsdioden oberhalb 200 V liegt. Insbesondere liegt die Durchbruchsspannung der hochsperrenden InGaAs Halbleiterleistungsdioden in einem Bereich zwischen 300V und 2000 V oder in einem Bereich zwischen 600 V und 1200 V oder in einen Bereich zwischen 1000 V und 1400 V oder in einen Bereich zwischen 1200 V und 2000 V.

Ein Vorteil von einer Gitterkonstante oberhalb von GaAs ist es, dass sich aufgrund der sich die hierdurch ergebende kleinere Bandlücke im Vergleich zu GaAs kleinere Vorwärtsspannungen als bei GaAs erzielen lassen. Anders ausgedrückt, durch den Einbau von Indium in GaAs lässt sich eine Bandlückenveränderung realisieren. InGaAs mit einer Gitterkonstante oberhalb von GaAs weist eine kleiner Bandlücke als GaAs auf, hierdurch lassen sich kleinere Vorwärtsspannungen bei der Diode realisieren, d.h. die Effizienz der Diode steigt.

Mit einer geringeren Vorwärtsspannung lassen sich im Durchlassfall die Verluste durch die InGaAs- Halbleiterleistungsdiode stark reduzieren. Mit einer höheren Beweglichkeit bei InGaAs im Vergleich zu GaAs verbessern sich die transienten elektrischen Eigenschaften, wie beispielsweise die Schaltfrequenz und der Serienwiderstand der InGaAs-Halbleiterleistungsdiode.

Ein anderer Vorteil ist, dass bei der InGaAs Halbleiterleistungsdiode im Vergleich zu Silizium und zu SiC insbesondere die Elektronen eine kleinere effektive Masse bzw. eine höhere Beweglichkeit aufweisen.

Auch lassen sich mit den InGaAs-Halbleiterleistungsdioden im Vergleich zu Si höhere Temperaturen an den p/n-Übergängen erreichen, ohne dass die InGaAs Halbleiterleistungsdioden zerstört werden. So lassen sich InGaAs- Halbleiterleistungsdioden bis zu Temperaturen von 300°C, d.h. auch in heißen Umgebungen, einsetzen.

Ein weiterer Vorteil im Vergleich zu SiC ist, dass sich InGaAs-Halbleiterleistungsdioden wesentlich kostengünstiger als Halbleiterstrukturen aus SiC mit vergleichbaren elektrischen Eigenschaften herstellen lassen.

Vorzugsweise liegt die Gitterkonstante der Verbindung von InGaAs im Bereich von der Gitterkonstante von InP oder die InGaAs Verbindung weist genau die Gitterkonstante wie InP auf. In einer Weiterbildung ist zwischen der Driftschicht und der zweiten metallischen Anschlussschicht eine Substratschicht von dem ersten Leitfähigkeitstyp oder von dem zweiten Leitfähigkeitstyp ausgebildet.

Erfindungsgemäß umfasst die Halbleiterkontaktschicht die Substratschicht oder die Halbleiterkontaktschicht besteht aus der Substratsschicht, wobei die Substratschicht InP umfasst oder aus InP besteht.

Erfindungsgemäß ist zwischen der Driftschicht und der zweiten metallischen Anschlussschicht eine Substratschicht von dem ersten Leitfähigkeitstyp oder von dem zweiten Leitfähigkeitstyp ausgebildet ist und die Substratschicht eine Schichtfolge mit InP und GaAs umfasst oder aus der Schichtfolge InP und GaAs besteht.

In einer Ausführungsform grenzt der Halbleiterkontaktbereich unmittelbar an die Driftschicht an.

Alternativ ist der hochdotierte Halbleiterkontaktbereich durch eine dotierte Zwischenschicht eines ersten Leitfähigkeitstyps mit einer Dotierstoffkonzentration kleiner als 5•10¹⁵ N/cm³ und mit einer ersten Gitterkonstante und mit einer Dicke zwischen 1 µm und 30 µm von der Driftschicht beabstandet, wobei die Zwischenschicht eine InGaAs Verbindung umfasst oder aus InGaAs besteht. Vorzugsweise umfasst die Zwischenschicht gemäß alternativer Weiterbildungen als Dotierstoffe Zink und / oder Silizium und / oder Kohlenstoff. Die Dotierstoffkonzentration der Zwischenschicht ist bevorzugt kleiner als die Dotierstoffkonzentration des unmittelbar an die Zwischenschicht angrenzenden hochdotierten Halbleiterkontaktbereichs. Insbesondere ist die Dotierstoffkonzentration der Zwischenschicht in einem Bereich zwischen einem Faktor 2 bis zu einem Faktor von vier Größenordnungen kleiner als die Dotierstoffkonzentration des unmittelbar an die Zwischenschicht angrenzenden hochdotierten Halbleiterkontaktbereichs.

Vorzugsweise ist die Dotierstoffkonzentration der Zwischenschicht größer als die Dotierstoffkonzentration der Driftschicht. Höchst vorzugsweise ist die Dotierstoffkonzentration der Zwischenschicht mindestens um einen Faktor 2 bis zu einem Faktor 100 oder mindestens um einen Faktor 10 bis zu einem Faktor 50 größer als die Dotierstoffkonzentration der Driftschicht.

Es versteht sich, dass in allen Ausführungsformen die Zwischenschicht einen anderen Leitfähigkeitstyp als die Driftschicht aufweist, so dass sich der p/n Übergang der Halbleiterleistungsdiode jeweils zwischen der Driftschicht und der Zwischenschicht ausbildet, sofern eine Zwischenschicht ausgebildet ist.

Vorzugsweise ist die Zwischenschicht p-dotiert ausgebildet.

Gemäß der Erfindung sind die erste metallische Anschlusskontaktschicht stoffschlüssig mit dem Halbleiterkontaktbereich und die zweite metallische Anschlusskontaktschicht stoffschlüssig mit der Halbleiterkontaktschicht verbunden.

Gemäß der Erfindung ist zwischen der Driftschicht und der zweiten metallischen Anschlusskontaktschicht eine hochdotierte metamorphe Pufferschichtfolge aus InGaAs ausgebildet. Die metamorphe Pufferschichtfolge weist eine Dotierstoffkonzentration größer als 1•10¹⁷ N/cm³ und eine Schichtdicke oberhalb 0,5 µm und kleiner als 20 µm auf.

Die metamorphe Pufferschichtfolge ist von dem ersten Leitfähigkeitstyp oder von dem zweiten Leitfähigkeitstyp, wobei die metamorphe Pufferschichtfolge eine Oberseite mit der ersten Gitterkonstante und eine Unterseite mit der zweiten Gitterkonstante aufweist, wobei die Oberseite in Richtung der Driftschicht angeordnet ist und die erste Gitterkonstante größer oder kleiner als die zweite Gitterkonstante ist.

Ein Vorteil der unterschiedlichen Gitterkonstanten ist es, dass sich InGaAs-Verbindungen mit kleinerer Gitterkonstante oder größerer Gitterkonstante als die von InP oberhalb der metamorphen InGaAs-Pufferschichtfolge ausbilden lassen. Dadurch kann die Bandlücke der InGaAs-Verbindungen oberhalb der metamorphen Pufferschichtfolge gezielt eingestellt werden und ist somit unabhängig von der Gitterkontante der unterhalb der metamorphen Pufferschichtfolge liegenden InP-Schicht.

Anders ausgedrückt, mittels der metamorphen Pufferschichtfolge lassen sich die oberhalb der metamorphen Pufferschichtfolge liegenden aktiven Schichten der hochsperrenden InGaAs-Halbleiterleistungsdiode hinsichtlich der elektrischen Eigenschaften von den elektrischen Eigenschaften der unterhalb liegenden Schichten aus InP oder zumindest mit der Gitterkonstante aus InP zumindest teilweise entkoppeln.

Erfindungsgemäß ist unterhalb der metamorphen Pufferschichtfolge eine Substratschicht von dem ersten Leitfähigkeitstyp oder von dem zweiten Leitfähigkeitstyp vorgesehen.

In einer anderen Ausführungsform ist die metamorphe Pufferschichtfolge durch eine dotierte Zwischenschicht eines ersten Leitfähigkeitstyps oder eines zweiten Leitfähigkeitstyps mit einer Dotierstoffkonzentration kleiner als 5•10¹⁵ N/cm³ und mit einer ersten Gitterkonstante und mit einer Dicke zwischen 1 µm und 30 µm von der Driftschicht beabstandet.

In einer nicht beanspruchten Weiterbildung ist die metamorphe Pufferschichtfolge als Halbleiterkontaktschicht ausgebildet. Ein Vorteil ist, dass hierdurch die stapelförmige hochsperrende III-V-Halbleiterleistungsdiode dünner ist, als mit einem unterhalb der Pufferschichtenfolge ausgebildetem Substrat. Es versteht sich, dass sich der Serienwiderstand der stapelförmigen Halbleiterleistungsdiode mit abnehmender Dicke der Schichtenfolge reduziert und sich die transienten Eigenschaften der Halbleiterleistungsdiode entsprechend verbessern.

Vorzugsweise ist die Gesamtdicke der Pufferschichtenfolge geringer als 30 µm oder geringer als 20 µm oder kleiner als 5 µm, aber größer als 0,2 µm. Hierdurch liegt die Gesamtdicke des Stapels der III-V Halbleiterleistungsdiode in einem Bereich zwischen 15 µm bis 30 µm oder in einen Bereich zwischen 20 µm und 40 µm oder ist kleiner als 60 µm oder ist kleiner als 40 µm oder ist kleiner als 120 µm oder ist kleiner als 180 µm.

In einer Ausführungsform besteht die metamorphe Pufferschichtfolge aus InₓGa₁₋ₓAs mit 0,1≤x≤1, wobei an einer Unterseite x=0,53 ist und x an der Oberseite größer oder kleiner als der Wert von x an der Unterseite ist. Vorzugsweise liegt der Grenzwert bei x < 1, höchst vorzugsweise bei x<0,8 oder bei x<0,6 oder bei x= 0,5.

Im Allgemeinen nimmt x zwischen den einzelnen Schichten der Pufferschichtenfolge ausgehend von der Unterseite bis hin zur Oberseite der Pufferschichtenfolge zu oder ab, wobei in einer alternativen Ausführungsform bei wenigen unmittelbar aufeinanderfolgenden Schichten der Wert von x etwas abnimmt oder zunimmt.

Zwischen der Mehrzahl der Schichten der Pufferschichtenfolge nimmt der Wert von x zwischen zwei unmittelbar aufeinanderfolgenden Schichten zu oder ab. Hierbei erfolgt die Zunahme oder die Abnahme von x entweder stufenförmig oder linear oder anderweitig.

In einer Weiterbildung nimmt der Wert von x von der Unterseite bis hin zu der Oberseite monoton zu oder monoton ab. In einer andern Weiterbildung weist der Wert von x in der Nähe der Oberseite der Pufferschichtenfolge ein lokales Maximum oder ein lokales Minimum auf und nimmt in Richtung der Oberseite ab oder zu. Vorzugsweise ist der Wert von x innerhalb der jeweiligen Schicht der Pufferschichtfolge konstant.

In einer Ausführungsform ist die InP-Substratschicht als Halbleiterkontaktschicht von dem zweiten Leitfähigkeitstyp oder von dem ersten Leitfähigkeitstyp ausgebildet. Vorzugsweise liegt die Dicke der Substratschicht zwischen 10 µm und 250 µm. Alternativ liegt die Dicke der Substratschicht zwischen 50 µm und 130 µm oder zwischen 150 µm und 650 µm.

In einer Weiterbildung ist eine zweite hochdotierte Halbleiterschicht mit der ersten Gitterkonstante zwischen der metamorphen Pufferschichtfolge und der Driftschicht ausgebildet. Die zweite hochdotierte Halbleiterschicht ist von dem zweiten Leitfähigkeitstyp oder von dem ersten Leitfähigkeitstyp und weist eine Dotierstoffkonzentration größer als 1•10¹⁸ N/cm³ und eine Schichtdicke oberhalb von 0,1 µm auf.

Alternativ weist die zweite hochdotierte Halbleiterschicht eine Dotierstoffkonzentration zwischen 5•10¹⁸ N/cm³ und 5•10¹⁹ N/cm³ und eine Schichtdicke zwischen 0,5 µm und 4 µm auf.

In einer anderen Ausführungsform ist der erste Leitfähigkeitstyp p und der zweite Leitfähigkeitstyp n oder der erste Leitfähigkeitstyp n und der zweite Leitfähigkeitstyp p.

Vorzugsweise ist der Halbleiterkontaktbereich als planare Schicht oder wannenförmig ausgebildet. Insbesondere bei einer epitaktischen Ausbildung ist der hochdotierte Halbleiterkontaktbereich als planare Schicht ausgebildet, während bei einer Implantation der hochdotierte Halbleiterkontaktbereich vorzugsweise wannenförmig ausgebildet ist, indem zur Ausbildung des Halbleiterkontaktbereichs Dotierstoffe in den Bereich der Driftschicht implantiert sind.

In einer Weiterbildung besteht die erste hochdotierte Halbleiterschicht aus GaAs oder aus InGaAs oder die erste Halbleiterschicht umfasst eine GaAs Verbindung oder eine InGaAs Verbindung. Vorzugsweise umfasst die Driftschicht und der Halbleiterkontaktbereich jeweils eine InGaAs Verbindung oder bestehen jeweils aus InGaAs.

In einer Ausführungsform sind der Halbleiterkontaktbereich und die Halbleiterschichten, d.h. der Stapel der Halbleiterleistungsdiode monolithisch ausgebildet.

Anders ausgedrückt die Schichten sind stapelförmig ohne Halbleiterbond aufeinander angeordnet.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: eine Querschnittsansicht auf eine erste nicht erfindungsgemäße Ausführungsform einer Halbleiterleistungsdiode,
- Figur 2: eine Querschnittsansicht auf eine zweite nicht erfindungsgemäße Ausführungsform einer Halbleiterleistungsdiode,
- Figur 3: eine Querschnittsansicht auf eine dritte nicht erfindungsgemäße Ausführungsform einer Halbleiterleistungsdiode,
- Figur 4: eine Querschnittsansicht auf eine vierte nicht erfindungsgemäße Ausführungsform einer Halbleiterleistungsdiode,
- Figur 5: eine Querschnittsansicht auf eine fünfte nicht erfindungsgemäße Ausführungsform einer Halbleiterleistungsdiode,
- Figur 6: eine Querschnittsansicht auf eine sechste nicht erfindungsgemäße Ausführungsform einer Halbleiterleistungsdiode,
- Figur 7: eine Querschnittsansicht auf eine siebente nicht erfindungsgemäße Ausführungsform einer Halbleiterleistungsdiode,
- Figur 8: eine Querschnittsansicht auf eine achte nicht erfindungsgemäße Ausführungsform einer Halbleiterleistungsdiode,
- Figur 9: eine Querschnittsansicht auf eine erste erfindungsgemäße Ausführungsform einer Halbleiterleistungsdiode,
- Figur 10: eine Querschnittsansicht auf eine zweite erfindungsgemäße Ausführungsform einer Halbleiterleistungsdiode.

Bei allen Abbildungen ist aus Gründen der Übersichtlichkeit jeweils nur eine Schnittansicht bzw. eine Querschnittsansicht einer stapelförmigen hochsperrenden InGaAs-Halbleiterleistungsdiode LHD dargestellt. Der Schichtstapel weist eine Oberseite und eine Unterseite auf.

Es versteht sich, dass an der Unterseite trotz der Bezeichnung als InGaAs-Halbleiterleistungsdioden LHD in einem Teil der Ausführungsformen ein InP Substrat ausgebildet ist.

Es sei angemerkt, dass alle in der Schnittansicht abgebildeten InGaAs-Halbleiterleistungsdioden LHD in einer Draufsicht entweder einen quadratischen oder einen rechteckigen oder einen runden Umfang oder einen rechteckigen Umfang mit abgerundeten Kanten aufweisen.

Anders ausgedrückt, in der Draufsicht weisen die InGaAs-Halbleiterleistungsdioden LHD die gleichen Schichtfolgen wie in der jeweiligen Querschnittsansicht auf, wobei nur die oberste Schicht zu sehen ist.

Auch gilt, dass die Halbleiterkontaktbereiche und die Halbleiterschichten jeweils eine InGaAs Verbindung umfassen oder aus InGaAs bestehen, wobei jeder Halbleiterbereich und jede Halbleiterschicht jeweils eine Oberseite und eine Unterseite aufweisen.

Die Oberseite zeigt hierbei jeweils in Richtung des an der Oberseite des Schichtstapels angeordneten Metallkontakts bzw. metallischen Anschlusskontakts, während die Unterseite jeweils in Richtung des an der Unterseite des Schichtstapels angeordneten Metallkontakts bzw. metallischen Anschlusskontakts zeigt.

Auch sei für alle Ausführungsformen angemerkt, dass der Ausdruck "Zwischenschicht" mit dem Ausdruck "Zwischenbereich" vorzugsweise synonym verwendet wird.

Jedoch wird mit dem Ausdruck "Zwischenbereich" oder mit dem Ausdruck "Halbleiterkontaktbereich" eine im Allgemeinen wannenförmige Ausbildung bezeichnet, demhingegen ist mit dem Ausdruck "Zwischenschicht" oder "Halbleiterkontaktschicht" im Allgemeinen jeweils eine Schicht mit zumindest einer planen Unterseite und / oder mit einer planen Oberseite bezeichnet.

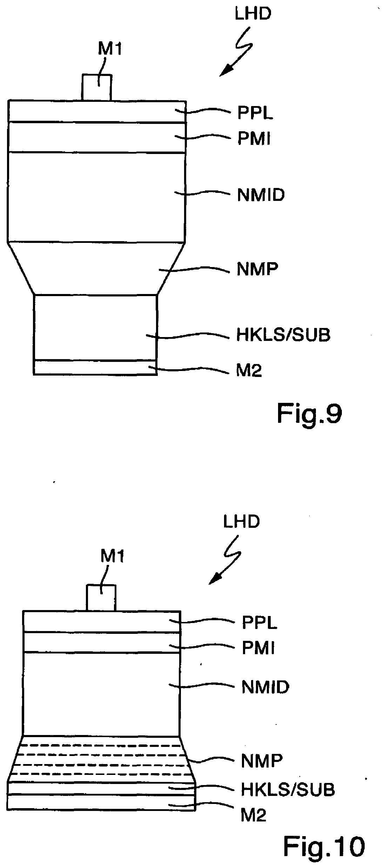

Insbesondere umfassen die in den Abbildungen 9 und 10 abgebildeten metamorphen Puffer eine Vielzahl von InGaAs-Halbleiterschichten oder bestehen aus einer Vielzahl von InGaAs-Halbleiterschichten, wobei sich die Gitterkonstante im Allgemeinen von InGaAs Halbleiterschicht zu InGaAs Halbleiterschicht ändert.

Unter einer Vielzahl wird vorliegend eine Anzahl von mindestens drei und maximal dreißig oder eine Anzahl von mindestens fünf und maximal zehn Halbleiterschichten verstanden. Des Weiteren ist der metamorphe Puffer jeweils möglichst niederohmig, d.h. hochdotiert ausgeführt.

Des Weiteren gilt für alle dargestellten Ausführungsformen, dass die InGaAs-Halbleiterleistungsdiode eine Oberseite und eine Unterseite aufweisen, wobei vorzugsweise mittels einer an der Unterseite ausgebildeten metallischen Anschlusskontaktschicht die InGaAs-Halbleiterleistungsdiode als sogenanntes "DIE" auf einer als Metallrahmen bzw. Metallträger auch "Leadframe" genannten Unterlage angeordnet sind.

Eine möglichst große insbesondere ganzflächige Ausbildung der metallischen Anschlusskontaktschicht an der Unterseite verbessert die thermische Ankopplung an die Unterlage.

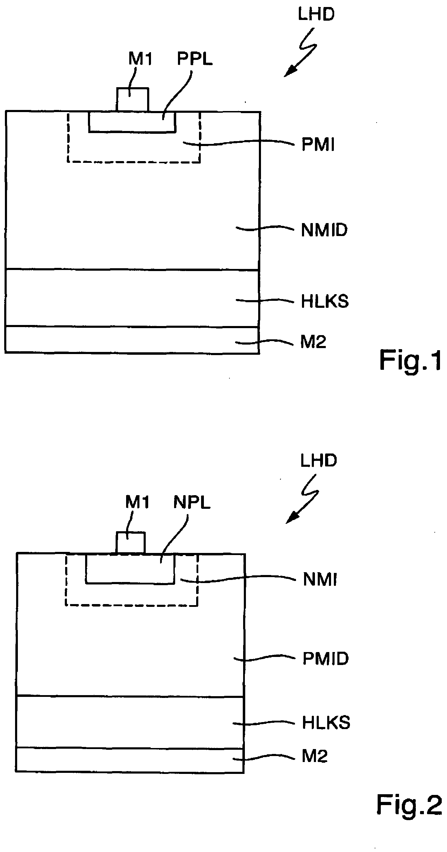

Die Abbildung der Figur 1 zeigt eine stapelförmige hochsperrende InGaAs-Halbleiterleistungsdiode LHD in einer p / n Struktur.

Die Halbleiterleistungsdiode LHD weist eine gebietsweise ausgebildete erste metallische Anschlusskontaktschicht M1 und einen p+ hochdotierten Halbleiterkontaktbereich PPL mit einer Dotierstoffkonzentration größer als 1•10¹⁸ N/cm³ und mit einer ersten Gitterkonstante auf.

Der Halbleiterkontaktbereich PPL ist wannenförmig ausgebildet und ist vorzugsweise mittels eines Masken- und Implantationsprozesses hergestellt. Hierbei werden Dotierstoffe in einen Bereich der n- Driftschicht oder der p-Driftschicht eingebracht, wobei vorzugsweise die Dotierstoffe mittels eines Temperaturprozesses aktiviert werden. Die erste metallische Anschlusskontaktschicht M1 und der p+ hochdotierte Halbleiterkontaktbereich PPL sind stoffschlüssig miteinander verbunden.

Zwischen dem p+ hochdotierten Halbleiterkontaktbereich PPL und einer n- Driftschicht NMID ist ein p- Zwischenbereich PMI in einer wannenförmigen Ausbildung angeordnet, so dass der p+ hochdotierte Halbleiterkontaktbereich PPL allseitig von der n- Driftschicht NMID beabstandet ist. Der p- dotierte Zwischenbereich PMI ist gestrichelt gezeichnet, da der p- dotierte Zwischenbereich PMI optional ist, d.h. in einer nicht dargestellten Ausführungsform ist der p- Zwischenbereich PMI nicht ausgebildet. Es versteht sich, dass ohne den p- Zwischenbereich PMI der p+ hochdotierte Halbleiterkontaktbereich PPL stoffschlüssig mit der n- Driftschicht NMID verbunden ist.

Der p- Zwischenbereich PMI weist eine Dotierung kleiner als p+ hochdotierte Halbleiterkontaktbereich PPL und größer als die n- Driftschicht NMID auf und ist stoffschlüssig mit dem p+ hochdotierte Halbleiterkontaktbereich PPL und der n-Driftschicht NMID verbunden. Der p- Zwischenbereich PMI weist eine Dotierstoffkonzentration kleiner als 5•10¹⁵ N/cm³ und die erste Gitterkonstante und eine Dicke zwischen 1 µm und 30 µm auf.

Die InGaAs Halbleiterleistungsdiode LHD weist neben der n- Driftschicht NMID mit der ersten Gitterkonstante und mit einer Schichtdicke größer als 10 µm auch eine n+ hochdotierte Halbleiterkontaktschicht HLKS mit einer Dotierstoffkonzentration größer als 5•10¹² N/cm³ und einer Schichtdicke oberhalb 0,5 µm und kleiner als 20 µm auf.

Die n- Driftschicht NMID und die n+ hochdotierte Halbleiterkontaktschicht HLKS sind stoffschlüssig miteinander verbunden. Die n+ hochdotierte Halbleiterkontaktschicht HLKS weist eine zweite Gitterkonstante auf, wobei die zweite Gitterkonstante gleich groß ist wie die erste Gitterkonstante, d.h. alle Halbleiterschichten des Stapels der Halbleiterleistungsdiode LHD sind zueinander gitterangepasst. Die Unterseite der hochdotierte Halbleiterkontaktschicht HLKS ist stoffschlüssig mit einer zweiten metallischen Anschlusskontaktschicht M2 verbunden.

Die vorgenannten Bereiche und Schichten sind in der genannten Reihenfolge angeordnet.

In einer alternativen nicht dargestellten Ausführungsform umfasst die hochsperrende InGaAs Halbleiterleistungsdiode weitere InGaAs Halbleiterschichten insbesondere an dem p/n Übergang und / oder zwischen einer sehr hochdotierten Halbleiterschicht oder einem sehr hochdotierten Halbleiterbereich mit einer Dotierstoffkonzentration oberhalb von 1•10¹² N/cm³ und einer niedrig dotierten Halbleiterschicht oder Halbleiterbereich mit einer Dotierstoffkonzentration unterhalb von 5•10¹² N/cm³.

Die Abbildung der Figur 2 zeigt eine stapelförmige hochsperrende III-V-Halbleiterleistungsdiode LHD in einer n / p Struktur. Die Halbleiterleistungsdiode LHD weist eine gebietsweise ausgebildete erste metallische Anschlusskontaktschicht M1 und einen n+ hochdotierten Halbleiterkontaktbereich NPL mit einer Dotierstoffkonzentration größer als 1•10¹⁸ N/cm³ und mit einer ersten Gitterkonstante auf.

Der Halbleiterkontaktbereich NPL ist wannenförmig ausgebildet und ist vorzugsweise mittels eines Masken- und Implantationsprozesses hergestellt. Die erste metallische Anschlusskontaktschicht M1 und der n+ hochdotierte Halbleiterkontaktbereich NPL sind stoffschlüssig miteinander verbunden.

Zwischen dem n+ hochdotierten Halbleiterkontaktbereich NPL und einer p- Driftschicht PMID ist ein n- Zwischenbereich NMI in einer wannenförmigen Ausbildung angeordnet, so dass der n+ hochdotierte Halbleiterkontaktbereich NPL allseitig von der p- Driftschicht PMID beabstandet ist. Der n- dotierte Zwischenbereich NMI ist gestrichelt gezeichnet, da der n- dotierte Zwischenbereich NMI optional ist, d.h. in einer nicht dargestellten Ausführungsform ist der n- Zwischenbereich NMI nicht ausgebildet.

Es versteht sich, dass ohne den n- Zwischenbereich NMI der n+ hochdotierte Halbleiterkontaktbereich NPL stoffschlüssig mit der p- Driftschicht PMID verbunden ist.

Der n- Zwischenbereich NMI weist eine Dotierung kleiner als der n+ hochdotierte Halbleiterkontaktbereich NPL und größer als die p- Driftschicht PMID auf und ist stoffschlüssig mit dem n+ hochdotierten Halbleiterkontaktbereich NPL und der p-Driftschicht PMID verbunden. Der n- Zwischenbereich NMI weist eine Dotierstoffkonzentration kleiner als 5•10¹⁵ N/cm³ und die erste Gitterkonstante und eine Dicke zwischen 1 µm und 30 µm auf.

Die InGaAs Halbleiterleistungsdiode LHD weist neben der p- Driftschicht PMID mit der ersten Gitterkonstante und mit einer Schichtdicke größer als 10 µm auch eine p+ hochdotierte Halbleiterkontaktschicht HLKS mit einer Dotierstoffkonzentration größer als 5•10¹² N/cm³ und einer Schichtdicke oberhalb 0,5 µm und kleiner als 20 µm auf.

Die p- Driftschicht PMID und die p+ hochdotierte Halbleiterkontaktschicht HLKS sind stoffschlüssig miteinander verbunden. Die p+ hochdotierte Halbleiterkontaktschicht HLKS weist eine zweite Gitterkonstante auf, wobei die zweite Gitterkonstante gleich groß ist wie die erste Gitterkonstante, d.h. alle Halbleiterschichten des Stapels der Halbleiterleistungsdiode LHD sind zueinander gitterangepasst. Die Unterseite der hochdotierte Halbleiterkontaktschicht HLKS ist stoffschlüssig mit einer zweiten metallischen Anschlusskontaktschicht M2 verbunden.

Die vorgenannten Bereiche und Schichten sind in der genannten Reihenfolge angeordnet. In einer alternativen nicht dargestellten Ausführungsform umfasst die hochsperrende InGaAs Halbleiterleistungsdiode weitere InGaAs Halbleiterschichten insbesondere an dem p/n Übergang und / oder zwischen einer sehr hochdotierten Halbleiterschicht oder Halbleiterbereich mit einer Dotierstoffkonzentration oberhalb von 1•10¹² N/cm³ und einer sehr niedrig dotierten Halbleiterschicht oder Halbleiterbereich mit einer Dotierstoffkonzentration unterhalb von 5•10¹⁷ N/cm³.

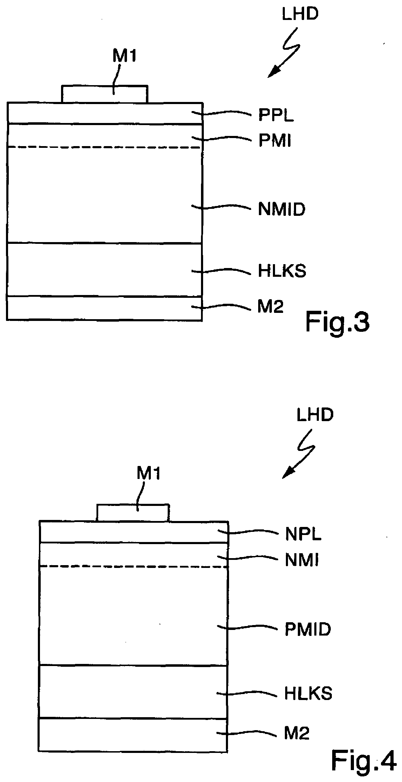

In der Figur 3 ist eine dritte Ausführungsform dargestellt. Im Folgenden werden nur die Unterschiede zu der Ausführungsform, dargestellt in Zusammenhang mit der Abbildung 1, erläutert.

Die Zwischenschicht PMI und die hochdotierte p+ Halbleiterkontaktschicht PPL sind jeweils plan ausgebildet. Derartige Schichtanordnungen werden mittels epitaktischer Prozesse insbesondere mittels einer MOVPE Anlage hergestellt. Die p- dotierte Zwischenschicht ist gestrichelt gezeichnet, da die p- dotierte Zwischenschicht optional ist, d.h. in einer nicht dargestellten Ausführungsform ist die p- Zwischenschicht nicht ausgebildet.

In der Figur 4 ist eine vierte Ausführungsform dargestellt. Im Folgenden werden nur die Unterschiede zu der Ausführungsform, dargestellt in Zusammenhang mit der Abbildung 2, erläutert.

Die Zwischenschicht NMI und die hochdotierte n+ Halbleiterkontaktschicht NPL sind jeweils plan ausgebildet. Derartige Schichtanordnungen werden mittels epitaktischer Prozesse insbesondere mittels einer MOVPE Anlage hergestellt. Die n- dotierte Zwischenschicht ist gestrichelt gezeichnet, da die n- dotierte Zwischenschicht optional ist, d.h. in einer nicht dargestellten Ausführungsform ist die n- Zwischenschicht nicht ausgebildet.

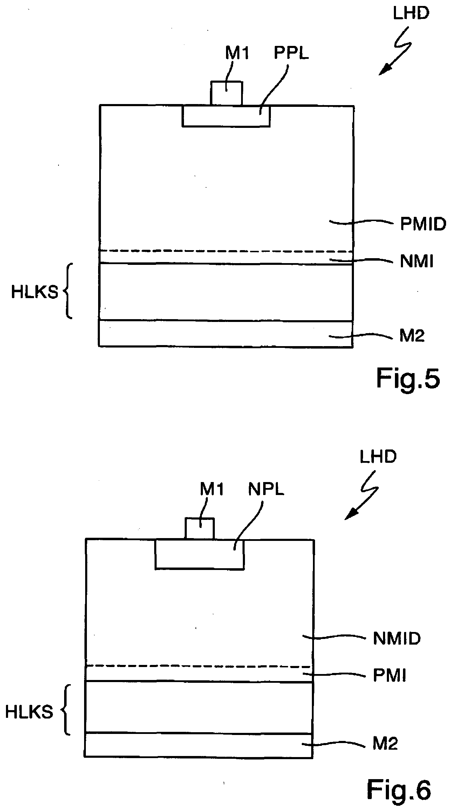

In der Figur 5 ist eine fünfte Ausführungsform dargestellt. Im Folgenden werden nur die Unterschiede zu der Ausführungsform, dargestellt in Zusammenhang mit der Abbildung 1, erläutert.

An den wannenförmig ausgebildeten hochdotierten p+ Halbleiterkontaktbereich PPL schließt sich stoffschlüssig die p- Driftschicht PMID an, wobei der p+ Halbleiterkontaktbereich PPL mittels einer Implantation in die p- Driftschicht PMID erzeugt ist. Hierdurch ist die p- Driftschicht an der Oberseite nicht mehr plan ausgebildet.

An die p- Driftschicht PMID schließt sich stoffschlüssig die n- dotierte Zwischenschicht NMI und die n+ hochdotierte Halbleiterkontaktschicht HLKS an, wobei die p- Driftschicht PMID an der Unterseite und die n+ hochdotierte Halbleiterkontaktschicht HLKS an der Oberseite und an der Unterseite plan ausgebildet ist.

Die n- dotierte Zwischenschicht NMI ist gestrichelt gezeichnet, da die n- dotierte Zwischenschicht NMI optional ist, d.h. in einer nicht dargestellten Ausführungsform ist die n- Zwischenschicht NMI nicht ausgebildet. Es versteht sich, dass ohne die n- Zwischenschicht NMI die Unterseite der p- Driftschicht PMID stoffschlüssig mit der Oberseite der n+ Halbleiterkontaktschicht HLKS verbunden ist.

In der Figur 6 ist eine sechste Ausführungsform dargestellt. Im Folgenden werden nur die Unterschiede zu der Ausführungsform, dargestellt in Zusammenhang mit der Abbildung 2, erläutert.

An den wannenförmig ausgebildeten hochdotierten n+ Halbleiterkontaktbereich NPL schließt sich stoffschlüssig eine n- Driftschicht NMID an, wobei der n+ Halbleiterkontaktbereich NPL mittels einer Implantation in die n- Driftschicht NMID erzeugt ist. Hierdurch ist die n- Driftschicht NMID an der Oberseite nicht mehr plan ausgebildet.

An die n- Driftschicht NMID schließt sich stoffschlüssig eine p- dotierte Zwischenschicht PMI und die p+ hochdotierte Halbleiterkontaktschicht HLKS an, wobei die n- Driftschicht NMID an der Unterseite und die p+ hochdotierte Halbleiterkontaktschicht HLKS an der Oberseite und an der Unterseite plan ausgebildet ist.

Die p- dotierte Zwischenschicht PMI ist gestrichelt gezeichnet, da die p- dotierte Zwischenschicht PMI optional ist, d.h. in einer nicht dargestellten Ausführungsform ist die p- Zwischenschicht PMI nicht ausgebildet. Es versteht sich, dass ohne die p- Zwischenschicht PMI die Unterseite der n- Driftschicht NMID stoffschlüssig mit der Oberseite der p+ Halbleiterkontaktschicht HLKS verbunden ist.

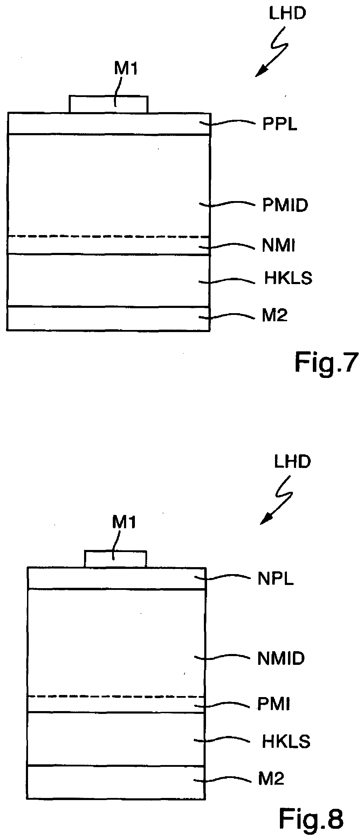

In der Figur 7 ist eine siebente Ausführungsform dargestellt. Im Folgenden werden nur die Unterschiede zu der Ausführungsform, dargestellt in Zusammenhang mit der Abbildung 5, erläutert.

An den schichtförmig ausgebildeten hochdotierten p+ Halbleiterkontaktbereich PPL schließt sich stoffschlüssig die p- Driftschicht PMID an, wobei der p+ Halbleiterkontaktbereich PPL mittels eines epitaktischen Prozessschrittes erzeugt ist. Hierdurch sind der p+ Halbleiterkontaktbereich PPL und die die p- Driftschicht PMID jeweils planar ausgebildet.

In der Figur 8 ist eine achte Ausführungsform dargestellt. Im Folgenden werden nur die Unterschiede zu der Ausführungsform, dargestellt in Zusammenhang mit der Abbildung 6, erläutert.

An den schichtförmig ausgebildeten hochdotierten n+ Halbleiterkontaktbereich NPL schließt sich stoffschlüssig die n- Driftschicht NMID an, wobei der n+ Halbleiterkontaktbereich NPL mittels eines epitaktischen Prozessschrittes erzeugt ist. Hierdurch sind der n+ Halbleiterkontaktbereich NPL und die die n- Driftschicht NMID jeweils planar ausgebildet.

In der Figur 9 ist eine erste erfindungsgemäße Ausführungsform einer p über n Struktur dargestellt. Im Folgenden werden insbesondere nur die Unterschiede zu den Ausführungsformen, dargestellt in Zusammenhang mit den Abbildungen der Figuren 1 und 3, erläutert.

Die an der Oberseite der stapelförmigen Halbleiterleistungsdiode LHD gebietsweise ausgebildete erste metallische Anschlusskontaktschicht M1 ist stoffschlüssig mit der Oberseite des aus einer InGaAs Verbindung bestehenden p+ hochdotierten Halbleiterkontaktbereich PPL verbunden. Der p+ hochdotierte Halbleiterkontaktbereich PPL ist mit der Unterseite stoffschlüssig mit der Oberseite der aus einer InGaAs Verbindung bestehenden p- Zwischenschicht PMI verbunden. Die Zwischenschicht PMI und die p+ hochdotierte Halbleiterkontaktschicht PPL sind jeweils plan ausgebildet, wobei die beiden Schichtanordnungen vorzugsweise mittels epitaktischer Prozesse insbesondere mittels einer MOVPE Anlage hergestellt sind.

Die Unterseite der p- Zwischenschicht PMI ist stoffschlüssig mit der Oberseite der aus einer InGaAs Verbindung bestehenden plan ausgebildeten n- Driftschicht NMID verbunden.

Die Unterseite der n- Driftschicht NMID ist stoffschlüssig mit der Oberseite einer aus einer InGaAs Verbindung bestehenden plan ausgebildeten n+ hochdotierten metamorphen Pufferschichtfolge NMP verbunden.

Die n+ hochdotierte metamorphe Pufferschichtfolge NMP weist eine Dotierstoffkonzentration größer als 5•10¹² N/cm³ oder größer als 1•10¹⁷ N/cm³ oder größer als 5•10¹⁶ N/cm³ oder größer als 2•10¹⁶ N/cm³ und eine Schichtdicke oberhalb 0,5 µm und kleiner als 20 µm auf. Die n- Driftschicht NMID und die n+ hochdotierte metamorphe Pufferschichtfolge NMP sind stoffschlüssig miteinander verbunden.

Es versteht sich, dass die Oberseite der n+ hochdotierten metamorphen Pufferschichtfolge NMP die gleiche Gitterkonstante aufweist wie die auf der Oberseite der n+ hochdotierten metamorphen Pufferschichtfolge NMP aufliegenden InGaAs Halbleiterschichten. Anders ausgedrückt, die aufliegenden InGaAs Halbleiterschichten sind zueinander gitterangepasst, wobei die Gitterkonstante der aufliegenden InGaAs Halbleiterschichten größer ist als die zweite Gitterkonstante und hierdurch größer als die Gitterkonstante von InP ist. Die Gitterkonstanten sind in der Fig. 9 durch die Breite der jeweiligen Halbleiterschichten bzw. des Halbleiterbereichs veranschaulicht.

Die Unterseite der n+ hochdotierten metamorphen Pufferschichtfolge NMP ist stoffschlüssig mit der Oberseite der n+ dotierten als ein Substrat SUB ausgebildeten Halbleiterkontaktschicht verbunden. Das n+ dotierte Substrat SUB besteht aus InP und ist vorzugsweise ungedünnt. Beispielsweise weist eine 4" InP-Scheibe eine Dicke von ca. 450 µm oder von 650 µm und eine 6" InP-Scheibe eine Dicke von ca. 725 µm auf.

Die Unterseite des n+ dotierten InP Substrats SUB ist stoffschlüssig mit der ganzflächig ausgebildeten zweiten metallischen Anschlussschicht M2 verbunden.

Die zweite metallische Anschlussschicht M2 besteht vorzugsweise aus einer Legierung aus Au und Pd.

In einer nicht dargestellten Ausführungsform sind zumindest teilweise die einzelnen aus der InGaAs-Verbindung bestehenden Halbleiterschichten nicht stoffschlüssig miteinander verbunden, indem weitere aus einer InGaAs-Verbindung bestehenden Schichten dazwischen ausgebildet sind. Beispielsweise lässt sich zwischen der n- Driftschicht NMID und der n+ hochdotierten metamorphen Pufferschichtfolge NMP eine weitere n- dotierte Zwischenschicht anordnen, wobei die weitere n- dotierte Zwischenschicht eine Dicke zwischen 3 µm und 15 µm aufweist. Des Weiteren ist die Dotierung der weiteren n- Zwischenschicht größer als die Dotierung der n- Driftschicht NMID jedoch kleiner als die Dotierung der n+ hochdotierten metamorphen Pufferschichtfolge NMP.

Auch sei angemerkt, dass anstelle der p über n Struktur sich auch eine n über p Struktur entsprechend der Ausführungsformen dargestellt in Zusammenhang mit den Abbildungen der Figuren 4 oder 6 oder 8 ausbilden lässt.

In der Figur 10 ist eine zweite erfindungsgemäße Ausführungsform dargestellt. Im Folgenden werden nur die Unterschiede zu der Ausführungsform, dargestellt in Zusammenhang mit der Abbildung 9, erläutert.

Die erste Gitterkonstante der auf der n+ hochdotierten metamorphen Pufferschichtfolge NMP aufliegenden InGaAs Halbleiterschichten ist kleiner als die zweite Gitterkonstante und hierdurch kleiner als die Gitterkonstante von InP. Wie in der Fig. 9 sind auch in der Fig. 10 die Gitterkonstanten durch die Breite der einzelnen Halbleiterschichten bzw. des Halbleiterbereichs veranschaulicht.

Die Unterseite der n+ hochdotierten metamorphen Pufferschichtfolge NMP ist stoffschlüssig mit der Oberseite der n+ dotierten als ein Substrat SUB ausgebildeten Halbleiterkontaktschicht HLKS verbunden, wobei das InP Substrat SUB gedünnt ist und eine Dicke zwischen 60 µm und 200 µm aufweist.

In nicht dargestellten Ausführungsformen sind zwischen der n+ hochdotierten metamorphen Pufferschichtfolge NMP und der zweiten metallischen Anschlusskontaktschicht M2 eine als Halbleiterkontaktschicht HKLS ausgebildete n+ erste hochdotierte Halbleiterschicht aus InGaAs angeordnet. Die erste hochdotierte Halbleiterschicht weist hierbei eine Dotierstoffkonzentration größer als 1•10¹⁸ N/cm³ und eine Schichtdicke oberhalb von 0,1 µm und kleiner als 10 µm oder kleiner als 5 µm auf.

Zwischen der n- Driftschicht NMID und der n+ hochdotierten metamorphen Pufferschichtfolge NMP ist eine zweite n+ hochdotierte Halbleiterschicht aus einer InGaAs Verbindung angeordnet. Es versteht sich, dass die Gitterkonstante der zweiten n+ hochdotierten Halbleiterschicht der Gitterkonstante der darüberliegenden n- Driftschicht NMID entspricht, d. h. die n+ zweite hochdotierte Halbleiterschicht und die n- Driftschicht NMID sind zueinander gitterangepasst.

Die zweite n+ hochdotierte Halbleiterschicht weist eine Dotierstoffkonzentration größer als 1•10¹⁸ N/cm³ und eine Schichtdicke oberhalb von 0,1 µm auf.

## Patentansprüche

1. Stapelförmige hochsperrende InGaAs-Halbleiterleistungsdiode (LHD), aufweisend
- eine zumindest gebietsweise ausgebildete erste metallische Anschlusskontaktschicht (M1),
- einen hochdotierten Halbleiterkontaktbereich (PPL, NPL) eines ersten Leitfähigkeitstyps mit einer Dotierstoffkonzentration größer als 1•10¹⁸ N/cm³ und mit einer ersten Gitterkonstante,
- eine Driftschicht (NMID, PMID) eines zweiten Leitfähigkeitstyps mit der ersten Gitterkonstante und mit einer Schichtdicke größer als 10 µm,
- eine Halbleiterkontaktschicht (HLKS) des zweiten Leitfähigkeitstyps mit einer Oberseite und einer Unterseite und mit einer Dotierstoffkonzentration größer als 5•10¹⁷ N/cm³ und einer Schichtdicke oberhalb 0,5 µm und kleiner als 850 µm,
eine zweite metallische Anschlusskontaktschicht (M2), wobei
- die vorgenannten Bereiche und Schichten in der genannten Reihenfolge angeordnet sind, und
- die zweite metallische Anschlusskontaktschicht (M2) stoffschlüssig mit der Unterseite der Halbleiterkontaktschicht (HLKS) verbunden ist, und
- die Halbleiterkontaktschicht (HLKS) eine zweite Gitterkonstante aufweist und die zweite Gitterkonstante die Gitterkonstante von InP ist, und
- die Driftschicht (NMID, PMID) und der hochdotierte Halbleiterkontaktbereich (PPL, NPL) jeweils eine InGaAs Verbindung umfassen oder aus InGaAs bestehen, und
- die erste Gitterkonstante oberhalb der Gitterkonstanten von GaAs liegt, und
zwischen der Driftschicht (NMID, PMID) und der zweiten metallischen Anschlusskontaktschicht (M2) eine hochdotierte metamorphe Pufferschichtfolge (NMP, PMP) ausgebildet ist und die metamorphe Pufferschichtfolge (NMP, PMP) eine Dotierstoffkonzentration größer als 2•10¹⁶ N/cm³ und einer Schichtdicke oberhalb 0,5 µm und kleiner als 20 µm aufweist und von dem zweiten Leitfähigkeitstyp ist und die metamorphe Pufferschichtfolge (NMP, PMP) eine Oberseite mit der ersten Gitterkonstante und eine Unterseite mit der zweiten Gitterkonstante aufweist, wobei die Oberseite in Richtung der Driftschicht (NMID, PMID) angeordnet ist und die erste Gitterkonstante größer oder kleiner als die zweite Gitterkonstante ist,
wobei die Halbleiterkontaktschicht (HLKS) eine Substratschicht (SUB) umfasst oder aus einer Substratschicht (SUB) besteht, und
die Substratschicht (SUB) InP umfasst oder aus InP besteht oder
eine Schichtfolge von InP und GaAs umfasst oder aus einer Schichtfolge aus InP und GaAs besteht.

2. Stapelförmige hochsperrende InGaAs-Halbleiterleistungsdiode (LHD), aufweisend
- eine zumindest gebietsweise ausgebildete erste metallische Anschlusskontaktschicht (M1),
- einen hochdotierten Halbleiterkontaktbereich (PPL, NPL) eines zweiten Leitfähigkeitstyps mit einer Dotierstoffkonzentration größer als 1•10¹⁸ N/cm³ und mit einer ersten Gitterkonstante,
- eine Driftschicht (NMID, PMID) des zweiten Leitfähigkeitstyps mit der ersten Gitterkonstante und mit einer Schichtdicke größer als 10 µm,
- eine Halbleiterkontaktschicht (HLKS) eines ersten Leitfähigkeitstyps mit einer Oberseite und einer Unterseite und mit einer Dotierstoffkonzentration größer als 5•10¹⁷ N/cm³ und einer Schichtdicke oberhalb 0,5 µm und kleiner als 850 µm,
eine zweite metallische Anschlusskontaktschicht (M2), wobei
- die vorgenannten Bereiche und Schichten in der genannten Reihenfolge angeordnet sind, und
- die zweite metallische Anschlusskontaktschicht (M2) stoffschlüssig mit der Unterseite der Halbleiterkontaktschicht (HLKS) verbunden ist,
und
- die Halbleiterkontaktschicht (HLKS) eine zweite Gitterkonstante aufweist und die zweite Gitterkonstante die Gitterkonstante von InP ist, und
- die Driftschicht (NMID, PMID) und der hochdotierte Halbleiterkontaktbereich (PPL, NPL) jeweils eine InGaAs Verbindung umfassen oder aus InGaAs bestehen, und
- die erste Gitterkonstante oberhalb der Gitterkonstanten von GaAs liegt, und
zwischen der Driftschicht (NMID, PMID) und der zweiten metallischen Anschlusskontaktschicht (M2) eine hochdotierte metamorphe Pufferschichtfolge (NMP, PMP) ausgebildet ist und die metamorphe Pufferschichtfolge (NMP, PMP) eine Dotierstoffkonzentration größer als 2•10¹⁶ N/cm³ und einer Schichtdicke oberhalb 0,5 µm und kleiner als 20 µm aufweist und von dem ersten Leitfähigkeitstyp ist und die metamorphe Pufferschichtfolge (NMP, PMP) eine Oberseite mit der ersten Gitterkonstante und eine Unterseite mit der zweiten Gitterkonstante aufweist, wobei die Oberseite in Richtung der Driftschicht (NMID, PMID) angeordnet ist und die erste Gitterkonstante größer oder kleiner als die zweite Gitterkonstante ist,
wobei die Halbleiterkontaktschicht (HLKS) eine Substratschicht (SUB) umfasst oder aus einer Substratschicht (SUB) besteht, und
die Substratschicht (SUB) InP umfasst oder aus InP besteht oder
eine Schichtfolge von InP und GaAs umfasst oder aus einer Schichtfolge aus InP und GaAs besteht.

3. Stapelförmige hochsperrende InGaAs-Halbleiterleistungsdiode (LHD) nach Anspruch 1, **dadurch gekennzeichnet, dass** der Halbleiterkontaktbereich (PPL, NPL) unmittelbar an die Driftschicht (NMID, PMID) angrenzt oder der Halbleiterkontaktbereich (PPL, NPL) durch eine dotierte Zwischenschicht (PMI, NMI) eines ersten Leitfähigkeitstyps mit einer Dotierstoffkonzentration kleiner als 5•10¹⁵ N/cm³ und mit der ersten Gitterkonstante und mit einer Dicke zwischen 1 µm und 30 µm von der Driftschicht (NMID, PMID) beabstandet ist und die Zwischenschicht (PMI, NMI) eine InGaAs Verbindung umfasst oder aus InGaAs besteht.

4. Stapelförmige hochsperrende InGaAs-Halbleiterleistungsdiode (LHD) nach Anspruch 2, **dadurch gekennzeichnet, dass** zwischen der metamorphen Pufferschichtfolge (NMP, PMP) und der Driftschicht (NMID, PMID) eine dotierte Zwischenschicht (PMI, NMI) eines ersten Leitfähigkeitstyps mit einer Dotierstoffkonzentration kleiner als 5•10¹⁵ N/cm³ und mit einer ersten Gitterkonstante und mit einer Dicke zwischen 1 µm und 30 µm ausgebildet ist und die Zwischenschicht (PMI, NMI) eine InGaAs Verbindung umfasst oder aus InGaAs besteht.

5. Stapelförmige hochsperrende InGaAs-Halbleiterleistungsdiode (LHD) nach einem der vorangegangenen Ansprüche, **dadurch gekennzeichnet, dass** der erste Leitfähigkeitstyp p und der zweite Leitfähigkeitstyp n ist oder der erste Leitfähigkeitstyp n und der zweite Leitfähigkeitstyp p ist.

6. Stapelförmige hochsperrende InGaAs-Halbleiterleistungsdiode (LHD) nach einem der vorangegangenen Ansprüche, **dadurch gekennzeichnet, dass** der Halbleiterkontaktbereich (PPL, NPL) als planare Schicht oder wannenförmig ausgebildet ist.

7. Stapelförmige hochsperrende InGaAs-Halbleiterleistungsdiode (LHD) nach einem der vorstehenden Ansprüche, **dadurch gekennzeichnet, dass** der Halbleiterkontaktbereich (PPL, NPL) und die weiteren Halbleiterschichten monolithisch ausgebildet sind.

8. Stapelförmige hochsperrende InGaAs-Halbleiterleistungsdiode (LHD) nach einem der vorstehenden Ansprüche, **dadurch gekennzeichnet, dass** die metamorphe Pufferschichtfolge aus InₓGa₁₋ₓAs mit 0,1≤×≤1, besteht, wobei an einer Unterseite x=0,53 ist und x an der Oberseite größer oder kleiner als der Wert von x an der Unterseite ist.

9. Stapelförmige hochsperrende InGaAs-Halbleiterleistungsdiode (LHD) nach einem der vorstehenden Ansprüche, **dadurch gekennzeichnet, dass** eine zweite hochdotierte Halbleiterschicht mit der ersten Gitterkonstante zwischen der metamorphen Pufferschichtfolge und der Driftschicht ausgebildet ist.

10. Stapelförmige hochsperrende InGaAs-Halbleiterleistungsdiode (LHD) nach einem der vorstehenden Ansprüche, **dadurch gekennzeichnet, dass** die Dicke der Substratschicht zwischen 10 µm und 250 µm liegt.

## Claims

1. Stacked high-barrier InGaAs semiconductor power diode (LHD), comprising
- a first metallic terminal contact layer (M1) formed at least regionally,
- a high-doped semiconductor contact region (PPL, NPL) of a first conductivity type with a dopant concentration greater than 1•10¹⁸ N/cm³ and with a first lattice constant,
- a drift layer (NMID, PMID) of a second conductivity type with the first lattice constant and with a layer thickness greater than 10 µm,
- a semiconductor contact layer (HLKS) of the second conductivity type with an upper side and a lower side and with a dopant concentration greater than 5•10¹² N/cm³ and a layer thickness above 0.5 µm and less than 850 µm,
a second metallic terminal contact layer (M2), wherein
- the aforesaid regions and layers are arranged in the stated sequence and
- the second metallic terminal contact layer (M2) is connected by material couple with the lower side of the semiconductor contact layer (HLKS) and
- the semiconductor contact layer (HLKS) has a second lattice constant and the second lattice constant is the lattice constant of InP and
- the drift layer (NMID, PMID) and the high-doped semiconductor contact region (PPL, NPL) each comprise an InGaAs compound or consist of InGaAs and
- the first lattice constant lies above the lattice constant of GaAs and
a high-doped metamorphic buffer layer sequence (NMP, PMP) is formed between the drift layer (NMID, PMID) and the second metallic contact layer (M2) and the metamorphic buffer layer sequence (NMP, PMP) has a dopant concentration greater than 2•10¹⁶ N/cm³ and a layer thickness above 0.5 µm and less than 20 µm and is of the second conductivity type and the metamorphic buffer layer sequence (NMP, PMP) has an upper side with the first lattice constant and a lower side with the second lattice constant, wherein the upper side is arranged in the direction of the drift layer (NMID, PMID) and the first lattice constant is greater or smaller than the second lattice constant,
wherein the semiconductor contact layer (HLKS) comprises a substrate layer (SUB) or consists of a substrate layer (SUB) and the substrate layer (SUB) comprises InP or consists of InP or comprises a layer sequence of InP and GaAs or consists of a layer sequence of InP and GaAS.

2. Stacked high-barrier InGaAs semiconductor power diode (LHD), comprising
- a first metallic terminal contact layer (M1) formed at least regionally,
- a high-doped semiconductor contact region (PPL, NPL) of a second conductivity type with a dopant concentration greater than 1•10¹⁸ N/cm³ and with a first lattice constant,
- a drift layer (NMID, PMID) of the second conductivity type with the first lattice constant and with a layer thickness greater than 10 µm,
- a semiconductor contact layer (HLKS) of a first conductivity type with an upper side and a lower side and with a dopant concentration greater than 5•10¹² N/cm³ and a layer thickness above 0.5 µm and less than 850 µm,
a second metallic terminal contact layer (M2), wherein
- the aforesaid regions and layers are arranged in the stated sequence and
- the second metallic terminal contact layer (M2) is connected by material couple with the lower side of the semiconductor contact layer (HLKS) and
- the semiconductor contact layer (HLKS) has a second lattice constant and the second lattice constant is the lattice constant of InP and
- the drift layer (NMID, PMID) and the high-doped semiconductor contact region (PPL, NPL) each comprise an InGaAs compound or consist of InGaAs and
- the first lattice constant lies above the lattice constant of GaAs and
a high-doped metamorphic buffer layer sequence (NMP, PMP) is formed between the drift layer (NMID, PMID) and the second metallic contact layer (M2) and the metamorphic buffer layer sequence (NMP, PMP) has a dopant concentration greater than 2•10¹⁶ N/cm³ and a layer thickness above 0.5 µm and less than 20 µm and is of the first conductivity type and the metamorphic buffer layer sequence (NMP, PMP) has an upper side with the first lattice constant and a lower side with the second lattice constant, wherein the upper side is arranged in the direction of the drift layer (NMID, PMID) and the first lattice constant is greater or smaller than the second lattice constant,
wherein the semiconductor contact layer (HLKS) comprises a substrate layer (SUB) or consists of a substrate layer (SUB) and the substrate layer (SUB) comprises InP or consists of InP or comprises a layer sequence of InP and GaAs or consists of a layer sequence of InP and GaAS.

3. Stacked high-barrier InGaAs semiconductor power diode (LHD) according to claim 1, **characterised in that** the semiconductor contact region (PPL, NPL) directly adjoins the drift layer (NMID, PMID) or the semiconductor contact region (PPL, NPL) is spaced from the drift layer (NMID, PMID) by a doped intermediate layer (PMI, NMI) of a first conductivity type with a dopant concentration less than 5.•10¹⁵ N/cm³ and with the first lattice constant and with a thickness between 1 µm and 30 µm and the intermediate layer (PMI, NMI) comprises an InGaAs compound or consists of InGaAs.

4. Stacked high-barrier InGaAs semiconductor power diode (LHD) according to claim 2, **characterised in that** a doped intermediate layer (PMI, NMI) of a first conductivity type with a dopant concentration less than 5•10¹⁵ N/cm³ and with a first lattice constant and with a thickness between 1 µm and 30 µm is formed between the metamorphic buffer layer sequence (NMP, PMP) and the drift layer (NMID, PMID) and the intermediate layer (PMI, NMI) comprises an InGaAs compound or consists of InGaAs.

5. Stacked high-barrier InGaAs semiconductor power diode (LHD) according to any one of the preceding claims, **characterised in that** the first conductivity type is p and the second conductivity type is n or the first conductivity type is n and the second conductivity type is p.

6. Stacked high-barrier InGaAs semiconductor power diode (LHD) according to any one of the preceding claims, **characterised in that** the semiconductor contact region (PPL, NPL) is formed as a planar layer or is formed to be trough-shaped.

7. Stacked high-barrier InGaAs semiconductor power diode (LHD) according to any one of the preceding claims, **characterised in that** the semiconductor contact region (PPL, NPL) and the further semiconductor layers are of monolithic construction.

8. Stacked high-barrier InGaAs semiconductor power diode (LHD) according to any one of the preceding claims, **characterised in that** the metamorphic buffer layer sequence consists of InₓGa₁₋ₓAs in which 0.1 ≤ x ≤ 1, wherein x = 0.53 at a lower side and x at the upper side is greater or smaller than the value of x at the lower side.

9. Stacked high-barrier InGaAs semiconductor power diode (LHD) according to any one of the preceding claims, **characterised in that** a second high-doped semiconductor layer with the first lattice constant is formed between the metamorphic buffer layer sequence and the drift layer.

10. Stacked high-barrier InGaAs semiconductor power diode (LHD) according to any one of the preceding claims, **characterised in that** the thickness of the substrate layer lies between 10 µm and 250 µm.

## Revendications

1. Diode empilée de puissance à semi-conducteur InGaAs à blocage haut (LHD), comprenant
- une première couche de contact métallique (M1) formée au moins par zones,
- une zone de contact semi-conductrice fortement dopée (PPL, NPL) d'un premier type de conductivité avec une concentration en dopant supérieure à 1•10¹⁸ N/cm³ et avec une première constante de réseau,
- une couche de dérive (NMID, PMID) d'un deuxième type de conductivité avec la première constante de réseau et avec une épaisseur de couche supérieure à 10 µm,
- une couche de contact semi-conductrice (HLKS) du deuxième type de conductivité avec une face supérieure et une face inférieure et avec une concentration en dopant supérieure à 5•10¹² N/cm³ et une épaisseur de couche supérieure à 0,5 µm et inférieure à 850 µm,
- une deuxième couche de contact métallique (M2),
- les zones et couches susmentionnées étant disposées dans l'ordre indiqué, et
- la deuxième couche de contact métallique (M2) étant reliée par adhérence à la face inférieure de la couche de contact semi-conductrice (HLKS), et
- la couche de contact semi-conductrice (HLKS) présentant une deuxième constante de réseau et la deuxième constante de réseau étant la constante de réseau de InP, et
- la couche de dérive (NMID, PMID) et la zone de contact semi-conductrice fortement dopée (PPL, NPL) comprenant chacune un composé InGaAs ou sont constituées de InGaAs, et
- la première constante de réseau étant supérieure aux constantes de réseau de GaAs, et
entre la couche de dérive (NMID, PMID) et la deuxième couche de contact métallique (M2), il est formé une séquence de couches tampons métamorphiques fortement dopées (NMP, PMP) et la séquence de couches tampons métamorphiques (NMP, PMP) présente une concentration en dopant supérieure à 2•10¹⁶ N/cm³ et une épaisseur de couche supérieure à 0,5 µm et inférieure à 20 µm et est du deuxième type de conductivité, et la séquence de couches tampons métamorphiques (NMP, PMP) présente une face supérieure avec la première constante de réseau et une face inférieure avec la deuxième constante de réseau, la face supérieure étant disposée en direction de la couche de dérive (NMID, PMID) et la première constante de réseau étant supérieure ou inférieure à la deuxième constante de réseau,
la couche de contact semi-conductrice (HLKS) comprenant une couche de substrat (SUB) ou étant constituée d'une couche de substrat (SUB), et
la couche de substrat (SUB) comprenant de l'InP ou étant constituée de InP ou comprenant une succession de couches de InP et de GaAs ou étant constituée d'une succession de couches de InP et de GaAs.

2. Diode empilée de puissance à semi-conducteur InGaAs à blocage haut (LHD), comprenant
- une première couche de contact métallique (M1) formée au moins par zones,
- une zone de contact semi-conductrice fortement dopée (PPL, NPL) d'un deuxième type de conductivité avec une concentration en dopant supérieure à 1•10¹⁸ N/cm³ et avec une première constante de réseau,
- une couche de dérive (NMID, PMID) du deuxième type de conductivité avec la première constante de réseau et une épaisseur de couche supérieure à 10 µm,
- une couche de contact semi-conductrice (HLKS) d'un premier type de conductivité avec une face supérieure et une face inférieure et avec une concentration en dopant supérieure à 5•10¹⁷ N/cm³ et une épaisseur de couche supérieure à 0,5 µm et inférieure à 850 µm,
une deuxième couche de contact métallique (M2),
- les zones et couches susmentionnées étant disposées dans l'ordre indiqué, et
- la deuxième couche de contact métallique (M2) étant reliée par adhérence à la face inférieure de la couche de contact semi-conductrice (HLKS), et
- la couche de contact semi-conductrice (HLKS) présentant une deuxième constante de réseau et la deuxième constante de réseau étant la constante de réseau de InP, et
- la couche de dérive (NMID, PMID) et la zone de contact semi-conductrice fortement dopée (PPL, NPL) comprenant chacune un composé InGaAs ou étant constituées de InGaAs, et
- la première constante de réseau étant supérieure aux constantes de réseau de GaAs, et
entre la couche de dérive (NMID, PMID) et la deuxième couche de contact métallique (M2), une séquence de couches tampons métamorphiques fortement dopées (NMP, PMP) est formée et la séquence de couches tampons métamorphiques (NMP, PMP) présente une concentration en dopant supérieure à 2•10¹⁶ N/cm³ et une épaisseur de couche supérieure à 0,5 µm et inférieure à 20 µm et est du premier type de conductivité, et la séquence de couches tampons métamorphiques (NMP, PMP) présente une face supérieure avec la première constante de réseau et une face inférieure avec la deuxième constante de réseau, la face supérieure étant disposée en direction de la couche de dérive (NMID, PMID) et la première constante de réseau étant supérieure ou inférieure à la deuxième constante de réseau,
la couche de contact semi-conductrice (HLKS) comprenant une couche de substrat (SUB) ou étant constituée d'une couche de substrat (SUB), et
la couche de substrat (SUB) comprenant de l'InP ou étant constituée de InP ou comprenant une séquence de couches de InP et de GaAs ou étant constituée d'une séquence de couches de InP et de GaAs.

3. Diode empilée de puissance à semi-conducteur InGaAs à blocage haut (LHD) selon la revendication 1, **caractérisée en ce que** la zone de contact semi-conductrice (PPL, NPL) est directement adjacente à la couche de dérive (NMID, PMID) ou la zone de contact semi-conductrice (PPL, NPL) est séparée de la couche de dérive (NMID, PMID) par une couche intermédiaire dopée (PMI, NMI) d'un premier type de conductivité avec une concentration en dopant inférieure à 5• 10¹⁵ N/cm³ et avec la première constante de réseau et avec une épaisseur comprise entre 1 µm et 30 µm (NMID, PMID) et la couche intermédiaire (PMI, NMI) comprend une liaison InGaAs ou est constituée d'InGaAs.

4. Diode empilée de puissance à semi-conducteur InGaAs à blocage haut (LHD) selon la revendication 2, **caractérisée en ce qu'**entre la séquence de couches tampons métamorphiques (NMP, PMP) et la couche de dérive (NMID, PMID) est formée une couche intermédiaire dopée (PMI, NMI) d'un premier type de conductivité avec une concentration en dopant inférieure à 5•10¹⁵ N/cm³ et avec une première constante de réseau et une épaisseur comprise entre 1 µm et 30 µm, et la couche intermédiaire (PMI, NMI) comprend une liaison InGaAs ou est constituée d'InGaAs.

5. Diode empilée de puissance à semi-conducteur InGaAs à blocage haut (LHD) selon l'une des revendications précédentes, **caractérisée en ce que** le premier type de conductivité est p et le deuxième type de conductivité est n ou le premier type de conductivité est n et le deuxième type de conductivité est p.

6. Diode empilée de puissance à semi-conducteur InGaAs à blocage haut (LHD) selon l'une des revendications précédentes, **caractérisée en ce que** la zone de contact semi-conductrice (PPL, NPL) est réalisée sous forme de couche plane ou en forme de cuvette.

7. Diode empilée de puissance à semi-conducteur InGaAs à blocage haut (LHD) selon l'une des revendications précédentes, **caractérisée en ce que** la zone de contact semi-conductrice (PPL, NPL) et les autres couches semi-conductrices sont réalisées de manière monolithique.

8. Diode empilée de puissance à semi-conducteur InGaAs à blocage haut (LHD) selon l'une des revendications précédentes, **caractérisée en ce que** la séquence de couches tampons métamorphiques est constituée de lnₓGa₁₋ₓAs avec 0,1≤x≤1, x étant égal à 0,53 sur une face inférieure et x étant supérieur ou inférieur à la valeur de x sur la face supérieure.

9. Diode empilée de puissance à semi-conducteur InGaAs à blocage haut (LHD) selon l'une des revendications précédentes, **caractérisée en ce qu'**une deuxième couche semi-conductrice fortement dopée avec la première constante de réseau est formée entre la séquence de couches tampons métamorphiques et la couche de dérive.

10. Diode empilée de puissance à semi-conducteur InGaAs à blocage haut (LHD) selon l'une des revendications précédentes, **caractérisée en ce que** l'épaisseur de la couche de substrat est comprise entre 10 µm et 250 µm.
